# EUROPEAN PATENT SPECIFICATION

(11) **EP 3 945 324 B1**
(45) Date of publication and mention of the grant of the patent: **22.07.2026**
(21) Application number: 20188431.9
(22) Date of filing: 29.07.2020
(51) Int. Cl.: G01R 19/00

(54) **TRANSISTOR PACKAGE WITH LOAD CURRENT SENSE MODALITY**
TRANSISTORGEHÄUSE MIT LASTSTROMFÜHLUNGSMODALITÄT
PAQUET DE TRANSISTOR DOTÉ D'UNE MODALITÉ DE DÉTECTION DE COURANT DE CHARGE

(43) Date of publication of application: 02.02.2022
(73) Proprietor: Infineon Technologies Austria AG, 9500 Villach (AT)
(72) Inventor: RIEGLER, Andreas, 9241 Lichtpold (AT); FACHMANN, Christian, 9586 Fürnitz (AT); KUTSCHAK, Matteo-Alessandro, 9072 Ludmannsdorf (AT); WEBER, Hans, 83457 Bayerisch Gmain (DE); WIEDENBAUER, Otto, 9500 Villach (AT)
(74) Representative: Lambsdorff & Lange Patentanwälte Partnerschaft mbB

(56) References cited:
- JP-B2- 6 605 393
- US-A1- 2008 191 779
- US-A1- 2017 092 596
- INFINEON: "OptiMOS TM Power-MOSFET Data Sheet BSB013NE2LXI rev. 2.4", 31 December 2013 (2013-12-31), pages 1 - 11, XP055769028, Retrieved from the Internet <URL:https://www.infineon.com/dgdl/Infineon-BSB013NE2LXI-DS-v02_04-en.pdf?fileId=db3a30432e398416012e47a158802577> [retrieved on 20210126]
- ON SEMICONDUCTOR: "AND8093/D Current Sensing Power MOSFETs - Application Note", 1 July 2002 (2002-07-01), pages 1 - 12, XP055209016, Retrieved from the Internet <URL:http://www.onsemi.com/pub_link/Collateral/AND8093-D.PDF> [retrieved on 20150821]

## Description

### Technical Field

This disclosure relates generally to the technique of switching and sensing load currents, and in particular to a transistor package having a load transistor and a load current sense modality.

### Background

Transistor packages are widely used as electronic switches in a variety of electronic circuits. In many applications it is desirable to sense and measure the load current flowing through the load transistor. Load current sensing may be useful in monitoring the load transistor with the aim to recognize performance degradation or other functional issues. Load current sensing may also be useful in monitoring the electronic consumer to detect consumer behavior such as the current energy consumption of the consumer. Further, adverse events (such as a short circuit) or technical faults can be detected.

Conventional current sensing in transistor packages is sometimes carried out by using a shunt resistor in the load current path. Another approach is to implement a sense transistor in the chip of the load transistor by dedicating a certain amount of transistor cells in the chip to the sense transistor. In this case, current sensing relies on passing a mirror current of the main load current through the sense transistor. This approach, however, increases the chip cost and may have limited versatility by imposing certain restrictions or requirements on consumer application.

US 2017/092596 A1 discloses a power module having two transistors each equipped with a source sense terminal.

The publication "OptiMOS TM Power-MOSFET Data Sheet BSB 013NE2LXI rev. 2.4", XP055769028, Infineon, discloses a power MOSFET module equipped with a gate terminal, two source terminals and a drain can terminal.

JP 6 605393 B2 discloses a package including two MOSFETs connected in parallel and configured to switch load currents.

US 2008/191779 A1 discloses a circuitry for determining the current in a load, the circuitry having a main transistor and a sense transistor.

The publication "AND8093/D Current Sensing Power MOSFETs - Application Note", XP055209016", describes a current sensing power MOSFET including two parallel FETs with common gate and drain connections and separate source leads.

### Summary

According to the invention, there is provided a transistor package, comprising: a first chip comprising a load transistor for switching a load current; a first load terminal, a second load terminal, and a control terminal, wherein the first load terminal, the second load terminal and the control terminal are package terminals, wherein the first load terminal is connected to a first load chip pad of the load transistor, the second load terminal is connected to a second load chip pad of the load transistor and the control terminal is connected to a control chip pad of the load transistor; the package further comprising: according to a first package type a second chip, the second chip comprising a sense transistor for sensing the load current, and a first type sense terminal connected to the sense transistor, the first type sense terminal being a package terminal, wherein a control chip pad of the sense transistor is connected to the control terminal, wherein a breakdown voltage of the sense transistor is higher than a breakdown voltage of the load transistor by at least 5% of the breakdown voltage of the load transistor; or according to a second package type a Kelvin sense terminal, the Kelvin sense terminal being connected to the first load chip pad, the Kelvin sense terminal being a package terminal; and a second type sense terminal connected to the second load chip pad of the load transistor via a Kelvin connection, the second type sense terminal being a package terminal accessible for external load current sensing.

According to another aspect of the disclosure, a circuitry for load current switching and load current sensing comprises the transistor package as described above. The circuitry further comprises a sense resistance connected between the first load terminal or a Kelvin sense terminal, the Kelvin sense terminal being connected to the first load chip pad, the Kelvin sense terminal being a package terminal and, if the transistor package is of the first package type, the first type sense terminal or, if the transistor package is of the second package type, a node connected to a package-external sense transistor for sensing the load current.

According to another aspect of the disclosure, a method of sensing a load current comprises connecting a sense resistance between the first load terminal or a Kelvin sense terminal, the Kelvin sense terminal being connected to the first load chip pad, the Kelvin sense terminal being a package terminal, and the first type sense terminal of a transistor package of the first package type as described above. A voltage drop across the sense resistance may be measured. The voltage drop is indicative of the level of the load current. Or a sense current flowing through the sense transistor is regulated for a voltage condition of zero volt across the sense resistance, the sense current being indicative of the level of the load current. Or a given reference voltage is compared with a voltage at the first type sense terminal, the comparison result being indicative of the level of the load current.

According to still another aspect of the disclosure, a method of sensing a load current comprises connecting a sense resistance between the first load terminal or a Kelvin sense terminal, the Kelvin sense terminal being connected to the first load chip pad, the Kelvin sense terminal being a package terminal, and a package-external sense transistor for a transistor package of the second package type as described above. A voltage drop across the sense resistance is measured. The voltage drop is indicative of the level of the load current. Or a sense current flowing through the package-external sense transistor is regulated for a voltage condition of zero volt across the sense resistance, the sense current being indicative of the level of the load current. Or a given reference voltage is compared with a voltage at a node connected to a package-external sense transistor for sensing the load current, the comparison result being indicative of the level of the load current.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1A is schematic diagram illustrating an example of a transistor package of the first package type "INT".
Figure 1B is schematic diagram illustrating an example of a transistor package of the second package type "EXT".
Figure 2 is a schematic cross-sectional view of a transistor package of the first package type "INT" having a first type sense terminal.
Figure 3 is a circuit diagram illustrating an exemplary circuitry for load current switching and load current sensing which uses a transistor package of the first package type "INT" and relies on sense resistance voltage drop measurement.
Figure 4 is a circuit diagram illustrating an exemplary circuitry for load current switching and load current sensing which uses a transistor package of the second package type "EXT" and relies on sense resistance voltage drop measurement.
Figure 5 is a circuit diagram illustrating an exemplary circuitry for load current switching and load current sensing which uses a transistor package of the first package type "INT" and relies on load current mirroring and sense current measurement.
Figure 6 is a circuit diagram illustrating another exemplary circuitry for load current switching and load current sensing which uses a transistor package of the first package type "INT" and relies on load current mirroring and sense current measurement.
Figure 7 is a circuit diagram illustrating an exemplary circuitry for load current switching and load current sensing which uses a transistor package of the first package type "INT" and relies on comparing a sense voltage with a given reference voltage for a high side load arrangement.
Figure 8 is a circuit diagram illustrating an exemplary circuitry for load current switching and load current sensing which uses a transistor package of the first package type "INT" and relies on comparing a sense voltage with a given reference voltage for a low side load arrangement.
Figure 9 is a flowchart illustrating methods of sensing a load current applicable for a transistor package of the first package type "INT".
Figure 10 is a flowchart illustrating methods of sensing a load current applicable for a transistor package of the second package type "EXT".

### Detailed description

It is to be understood that the features of the various exemplary embodiments and examples described herein may be combined with each other unless specifically noted otherwise.

As used in this specification, the terms "electrically connected" or "connected" or similar terms are not meant to mean that the elements are directly contacted together; intervening elements may be provided between the "electrically connected" or "connected" elements, respectively. However, in accordance with the disclosure, the above-mentioned and similar terms may, optionally, also have the specific meaning that the elements are directly contacted together, i.e. that no intervening elements are provided between the "electrically connected" or "connected" elements, respectively.

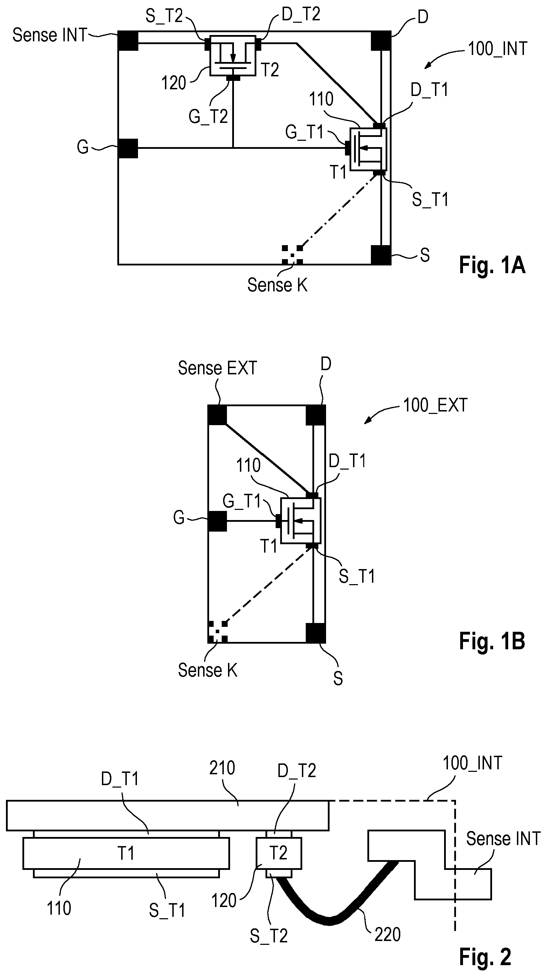

Referring to Figure 1A, a transistor package 110_INT may include a load transistor T1 and a sense transistor T2. The load transistor T1 is implemented in a first chip 110. The sense transistor T2 is implemented in a second chip 120. The first chip 110 and the second chip 120 are separate semiconductor bodies.

The load transistor T1 may be used as an electronic switch that switches a current provided to a load (not shown in Figure 1A). The sense transistor T2 may be used to sense the load current flowing through the load transistor T1.

The load transistor T1 has a first load node (e.g. source), a second load node (e.g. drain) and a control node (e.g. gate). The first load node is connected to a first load chip pad S_T1, the second load node is connected to a second load chip pad D_T1 and the control node is connected to a control chip pad G_T1 of the first chip 110.

Analogously, the sense transistor T2 has a first load node (e.g. source), a second load node (e.g. drain) and a control node (e.g. gate). The first load node of the sense transistor T2 is connected to a first load chip pad S_T2, the second load node is connected to a second load chip pad D_T2 and the control node is connected to a control chip pad G_T2 of the second chip 120.

The transistor package 100_INT comprises a first load terminal S, a second load terminal D, a control terminal G and a first type sense terminal SenseINT. These terminals are package terminals, i.e. are used for electrically connecting the transistor package 100_INT to external circuitry such as, e.g., an application board.

The first load terminal S of the transistor package 100_INT is connected to the first load chip pad S_T1 of the load transistor T1, the second load terminal D of the transistor package 100_INT is connected to the second load chip pad D_T1 of the load transistor T1 and the control terminal G of the transistor package 100_INT is connected to the control chip pad G_T1. Hence, the load current, which is switched by the load transistor T1, is flowing through a load current path of the transistor package 100_INT between the first load terminal S and the second load terminal D of the transistor package 100_INT.

The first load chip pad S_T2 of the sense transistor T2 is connected to the first type sense terminal SenseINT of the transistor package 100_INT, the second load chip pad D_T2 of the sense transistor T2 is connected to the second load chip pad D_T1 of the load transistor T1 and the control chip pad G_T2 of the sense transistor T2 is connected to the control chip pad G_T1 of the first chip 110. The control terminal G of the transistor package 100_INT is a common control terminal which may be connected to both control chip pads G_T1 and G_T2 of the load transistor T1 (i.e. of the first chip 110) and the sense transistor T2 (i.e. of the second chip 120), respectively.

The transistor package 100_INT may optionally comprise a Kelvin sense terminal SenseK as a further package terminal. The Kelvin sense terminal SenseK may be connected to the first load chip pad S_T1. Such connection is referred to in the art as a Kelvin connection. The Kelvin connection (together with the Kelvin sense terminal SenseK) allows to eliminate the resistance and temperature coefficient of the load current path connection between the first load terminal S of the transistor package 100_INT and the first load chip pad S_T1 of the load transistor T1.

Likewise, the connection between the first chip 110 and the second chip 120 or, more specifically, the connection between the second load chip pad D_T1 of the first chip 110 and the second load chip pad D_T2 of the second chip 120 may be a Kelvin connection.

For purpose of illustration and without loss of generality, the following description exemplarily relates, but is not restricted, to a first chip 110 with the first load chip pad S_T1 is the source chip pad, the second load chip pad D_T1 is the drain chip pad and the control chip pad G_T1 is the gate chip pad. Analogously, in the following description the first load chip pad S_T2 of the sense transistor T2 is, e.g., the source chip pad, the second load chip pad D_T2 of sense transistor T2 (i.e. of the second chip 120) is, e.g., the drain chip pad and the control chip pad G_T2 of the sense transistor T2 (i.e. of the second chip 120) is, e.g., the gate chip pad.

Further, for purpose of illustration only, the description exemplarily relates to a load transistor T1 which is a MOSFET (Metal Oxide Semiconductor Field-Effect Transistor), in particular an n-type enhancement MOSFET, and to a sense transistor T2 which is also a MOSFET, in particular also an n-type enhancement MOSFET. The disclosure, however, is not restricted to these transistor types, and other transistor types and/or other combinations of transistor types which could be used for the load transistor T1 and the sense transistor T2 will be described in more detail further below.

The concept of integrating two (separate) chips 110, 120 in the transistor package 100_INT allows for a greater flexibility and variety of applications as well as cost savings compared to conventional single-chip implementations of T1 and T2. For specific applications such as, e.g., electronic fuses (so-called eFUSE devices) or battery main switches (BMS) for battery management, a high measurement accuracy of load current sensing is not needed. These and other devices may employ load current sensing mainly for package diagnosis (e.g. to detect a short-circuit or to monitor the load transistor with the aim to recognize performance degradation or other functional issues of the transistor package) or for monitoring the electronic consumer (e.g. to detect consumer behavior or consumer issues such as, e.g., the current energy consumption of the consumer or a short-circuit at the consumer).

These and other devices may take benefit from the two chip concept as disclosed herein since the second chip 120 implementing the sense transistor T2 can be small and cheap. Further, as will be described in more detail further below, simple current sense circuitry and methods which basically rely on a package-external sense resistance can be used in combination with the transistor package concept in accordance with the disclosure.

The load transistor T1 and the sense transistor T2 are different in specifications. R_{ON}(T1) refers to the on-resistance of the load transistor T1 and R_{ON}(T2) refers to the on-resistance of the sense transistor T2. A ratio R_{ON}(T2)/R_{ON}(T1) may be equal to or greater than 20 or 50 or 100 or 200. In this embodiment, the transistor package 100_INT is configured to be used both for a first measurement method based on the measurement of a voltage drop across a sense resistance and for a second measurement method based on mirroring the load current through the sense transistor T2.

According to one embodiment, the ratio R_{ON}(T2)/R_{ON}(T1) may be equal to or greater than 1000 or 2000 or 5000. In this case, the package technology, as disclosed herein, is configured to be used, e.g., with a second measuring method relying on mirroring the load current through the sense transistor T2. The two measuring methods referred to above will be explained in more detail further below.

In one example, the on-resistance R_{ON}(T1) of the load transistor T1 is equal to or less than 100 mΩ or 10 mΩ or 5 mΩ. Load currents which are switched by the load transistor T1 may, e.g., be equal to or greater than 50 A or 100 A or 150 A or 200 A or 250 A, etc.

Figure 1B illustrates an example of a transistor package 100_EXT. The transistor package 100_EXT can be identical to the transistor package 100_INT except that the second chip 120 is sourced out of the transistor package 100_EXT. Instead of the second chip 120, the transistor package 100_EXT includes a second type sense terminal SenseEXT, which is a package terminal. The second type sense terminal SenseEXT is connected to the second load chip pad D_T1 of the first chip 110 implementing the load transistor T1. The connection between the second type sense terminal SenseEXT and the second load chip pad D_T1 is a Kelvin connection. Except this difference, the transistor package 100_INT and the transistor package 100_EXT may be identical. Hence, reference is made to the above description for the sake of brevity and to avoid reiteration.

Differently put, the package concepts exemplified by transistor package 100_INT and transistor package 100_EXT are different in that the second chip 120 (including the sense transistor T2) is a package-internal chip in transistor package 100_INT while this transistor is a package-external transistor (and therefore not shown in Figure 1B) in transistor package 100_EXT. Accordingly, transistor package 100_INT is an example of a first package type containing the second chip 120 while transistor package 100_EXT is an example of a second package type, which excludes the second chip 120 but instead offers the additional package terminal SenseEXT accessible for external load current sensing.

Figure 2 illustrates a schematic cross-sectional view of a transistor package of the first package type as exemplified by transistor package 100_INT of Figure 1A. The first chip 110 may be mounted on a leadframe 210. The leadframe 210 may be connected (e.g. soldered) to the second load chip pad D_T1.

The second chip 120 may also be mounted on the leadframe 210. More specifically, the second load chip pad D_T2 of the second chip 120 may be connected (e.g. soldered) to the leadframe 210. This allows for an efficient thermal connection between the two chips 110, 120. In particular, a diffusion solder may be used for both chips 110, 120 to enhance the thermal coupling between the two chips 110, 120.

The first load chip pad S_T2 of the second chip 120 may be connected via a bond wire 220 or another conductor to the first type sense terminal SenseINT of the transistor package 100_INT. The leadframe 210 may correspond to the second load terminal D of the transistor package 100_INT. The first load terminal S of the transistor package 100_INT, which is connected to the first load chip pad S_T1 of the load transistor T1, is not shown in Figure 2. Further, the control chip pads G_T1, G_T2 as well as the control terminal G of the transistor package 100_INT are not shown in Figure 2.

As to the second package type as exemplified by transistor package 100_EXT of Figure 1B, the schematic cross-sectional view of Figure 2 also applies to transistor package 100_EXT if the second chip 120 is removed and the bond wire 220 is directly connected to the second load chip pad D_T1 of the load transistor T1 or to the leadframe 210 at a location suitable for a Kelvin connection. The package terminal SenseINT of Figure 2 is then SenseEXT.

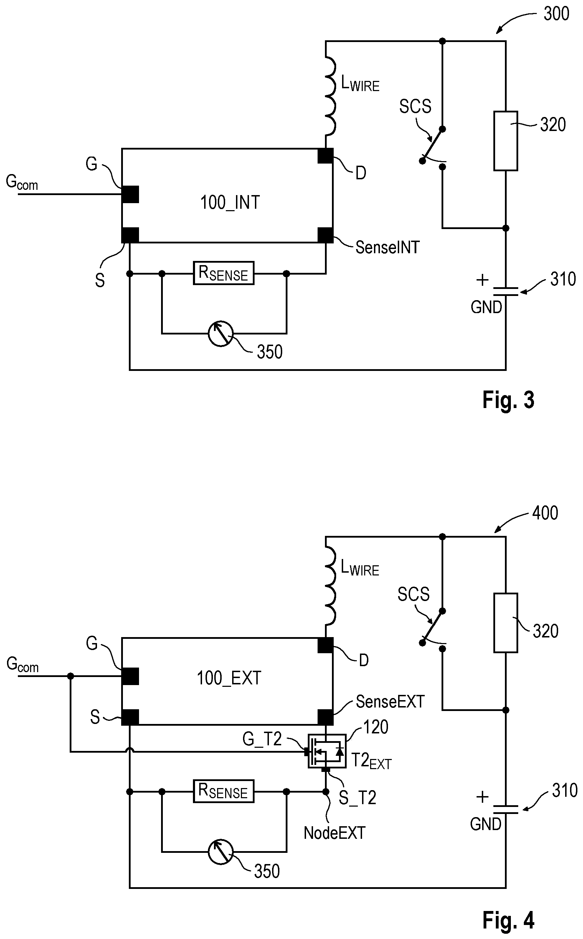

A transistor package of the first package type, e.g. transistor package 100_INT, may be integrated in an exemplary circuitry 300 for load current switching and load current sensing as shown in Figure 3. A sense resistance R_{SENSE} is connected between the first load terminal S and the first type sense terminal SenseINT. The circuitry 300 for load current switching and load current sensing further includes a direct current (DC) power supply 310, a load 320 connected to the power supply 310 and a voltage measurement device 350.

The first load terminal S may be connected to a ground (GND) node of the power supply 310. A node of positive potential of the power supply 310 may be connected to the load 320. The load 320 may be connected to the second load terminal D of the transistor package 100_INT. A common control signal G_{COM} of the external circuitry 300 may be connected to the control terminal G of the transistor package 100_INT.

The voltage measurement device 350 may be connected to measure the voltage drop across the sense resistance R_{SENSE}. Figure 3 further illustrates equivalent circuit elements such as, e.g., a short circuit switch SCS and a parasitic inductance L_{WIRE} of the conductor between the second load terminal D and the load 320.

The resistance R_{SENSE} may be dimensioned based on the circuitry 300. Thus, the dimensioning of R_{SENSE} may, e.g., be customer-specific. For instance, the resistance value of R_{SENSE} may be chosen such that the voltage drop across the sense resistance R_{SENSE} is approximately equal to the drain-source voltage V_{DS}(T1) of the load transistor T1. For instance, the resistance value of the sense resistance R_{SENSE} may be in a range between 100 Ω and 1 kΩ.

The circuitry 300 may, e.g., detect a short circuit at the load 320, as indicated by the equivalent short circuit switch SCS across the load 320, or a short circuit in the electrical circuitry connecting the load 320 with the transistor package 100_INT. In these cases, the load current will rise. Accordingly, the voltage drop across the sense resistance R_{SENSE} will suddenly rise. That way, the rise of the load current can be detected by the voltage measurement device 350. This measurement method has no sensitivity on parasitic inductances L_{WIRE} in the load current path.

The resistance value of R_{SENSE} may, e.g., be about 100 Ω. If, e.g., a measurement signal of a factor 10 higher is desired, then the resistance value of R_{SENSE} may be about 1 kΩ. Generally, a wide variety of values of R_{SENSE} is feasible, e.g. in a range from about 10 Ω to 5 kΩ.

Figure 4 illustrates an exemplary circuitry 400 for load current switching and load current sensing. The circuitry 400 is similar to the circuitry 300 of Figure 3 except that a transistor package of the second package type, e.g. in this example transistor package 100_EXT, is used.

According to Figure 4, the second chip 120 implementing a sense transistor T2_{EXT} is placed external of the transistor package 100_EXT. The sense transistor T2_{EXT} may have the same specifications as the (package-internal) sense transistor T2. Except of this modification the circuitry 400 for load current switching and load current sensing may be identical to the circuitry 300 for load current switching and load current sensing. Hence, reference is made to the above description in order to avoid reiteration.

As apparent from Figure 4, the second chip 120 including the sense transistor T2_{EXT} can now be chosen and dimensioned by the customer so as to be optimally adapted to the circuitry 400. This may increase the range of application of the transistor package 100_EXT in terms of its adaptability to different circuitry 400. In terms of its technical specifications the (external) sense transistor T2_{EXT} as well as the sense resistance R_{SENSE} may be dimensioned the same way as described above in conjunction with Figure 3.

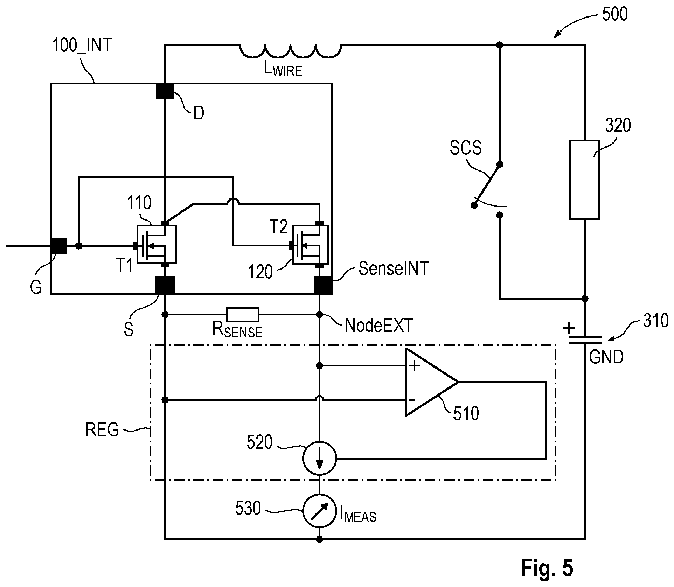

Figure 5 illustrates a circuitry 500 for load current switching and load current sensing. The circuitry 500 uses a different approach for current sensing as the approach disclosed in the examples of Figures 3 and 4. Similar reference signs as used before are related to the same elements. Similar to the circuitry 300, the circuitry 500 uses, e.g., a transistor package of the first package type, e.g. the transistor package 100_INT. The sense resistance R_{SENSE} is, again, connected between the first load terminal S of the transistor package 100_INT and the first type sense terminal SenseINT.

The circuitry 500 further includes a regulator REG configured to regulate the sense current flowing through the sense transistor T2. The regulator REG may, e.g., comprise an operational amplifier 510 and a current source 520.

In the steady-state operation the regulator REG sets the potential at the first type sense terminal SenseINT (and thus at the first load chip pad S_T2) to equal the potential at the first load terminal S of the transistor package 100_INT. Hence, no current is flowing through the sense resistance R_{SENSE} and the voltage drop across the sense resistance R_{SENSE} in steady-state operation is zero. For this reason, the sense resistance R_{SENSE} is also referred to as a pulldown resistance in this example.

If the load current suddenly increases, e.g. because of the occurrence of a short circuit symbolized by closing the short circuit switch SCS, the sense current, as being mirrored from the load current, also rises. This rise can be detected by current measurement at a current measurement device I_{MEAS} at 530. This measurement method has no sensitivity on parasitic inductances L_{WIRE} in the load current path.

The resistance value of the pulldown resistance R_{SENSE} can be designed to be in the kΩ range, e.g. equal to or greater than or less than 1 kΩ or 2 kΩ or 3 kΩ, ..., or 10 kΩ.

In Figure 5 the measurement method of regulating the sense current flowing through the sense transistor T2 for a voltage condition of zero volt across the (pulldown) sense resistance R_{SENSE} and measuring the sense current as being indicative of the level of the load current flowing through the load transistor T1 is disclosed for a transistor package 100_INT of the first package type. However, this measurement method as well as the circuitry 500 can likewise be applied to a transistor package of the second package type such as, e.g., transistor package 100_EXT. In this case, the (pulldown) sense resistance R_{SENSE} may be connected between the first load terminal S of the transistor package 100_EXT and a node NodeEXT, which is connected to the package-external sense transistor T2_{EXT} for sensing the load current as shown in Figure 4. For instance, the node NodeEXT may be connected to the first load chip pad S_T2 of the sense transistor T2_{EXT} of the second chip 120.

In one example, the sense resistance R_{SENSE} may be implemented as a discrete component which is located external to the regulator REG. In another example, the sense resistance R_{SENSE} may be an intrinsic resistance of the regulator REG, e.g. may be implemented as a discrete component located within the regulator REG or as a monolithically integrated component in the regulator REG. In the latter case, the sense resistance R_{SENSE} may, e.g., be the input resistance of the regulator REG which may, e.g., be determined by the IC (Integrated Circuit) technology (e.g. CMOS (Complementary Metal Oxide Semiconductor) technology) of the operational amplifier 510.

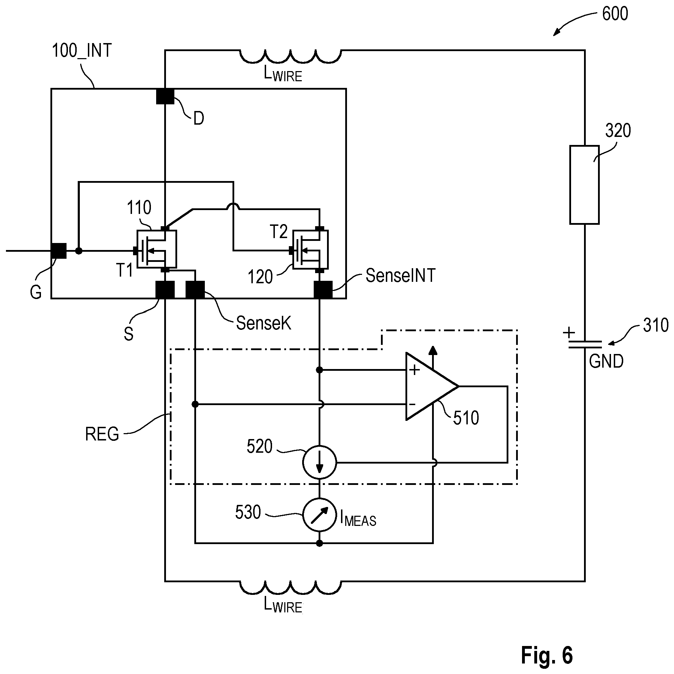

Figure 6 illustrates a circuitry 600 for load current switching and load current sensing. The circuitry 600 is similar to the circuitry 500 except that the input resistance of the operational amplifier 510 is used as the sense resistance R_{SENSE}. Further, and independently of this difference, Figure 6 exemplifies the possibility that the transistor package 100_INT includes a Kelvin sense terminal SenseK and that the operational amplifier 510 (and thus the sense resistance R_{SENSE} implemented therein) is connected to the Kelvin sense terminal SenseK rather than to the first load terminal (S). This may improve accuracy of the load current measurement.

In the steady-state operation the regulator REG sets the potential at the first type sense terminal SenseINT (and thus at the first load chip pad S_T2) to equal the potential at the Kelvin sense terminal SenseK of the transistor package 100_INT. The potential at the Kelvin sense terminal SenseK is exactly equal to the potential at the first load chip pad S_T1 of the load transistor T1. In the steady-state operation the measurement current I_{MEAS} at the current measurement device 530 may be written as I_{MEAS} = I_{LOAD} × R_{ON}(T1)/R_{ON}(T2), with I_{LOAD} being the load current at load 320.

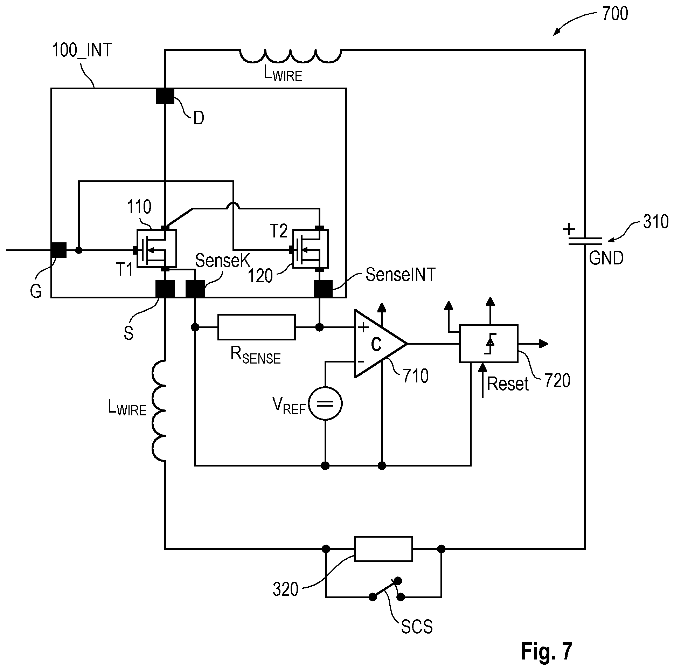

Figure 7 illustrates an exemplary circuitry 700 for load current switching and load current sensing which relies on comparing a sense voltage with a given reference voltage. The load 320 is connected to the ground (GND) node of the power supply 310, i.e. the circuitry 700 may relates to an overcurrent detection of a high side switch.

In circuitry 700 the sense resistance R_{SENSE} is connected between the Kelvin sense terminal SenseK and the first type sense terminal SenseINT of the transistor package of the first package type 100_INT. Alternatively, the sense resistance R_{SENSE} may be connected between the first load terminal S and the first type sense terminal SenseINT of the transistor package.

The circuitry 700 comprises a comparator 710 and, e.g., a latch 720. The comparator 710 compares a given reference voltage V_{REF} with a voltage at the first type sense terminal SenseINT. If the transistor package would be a transistor package 100_EXT of the second type, the comparator compares the given reference voltage V_{REF} with a voltage at a node NodeEXT (see Figure 4) connected to a package-external sense transistor T2_{EXT} for sensing the load current. The output of the comparator is indicative of a level of the load current. More specifically, the output is indicative of whether the load current is greater or smaller than a certain threshold current. The (optional) latch 720 may be used to store this output information as state information (overcurrent detection event).

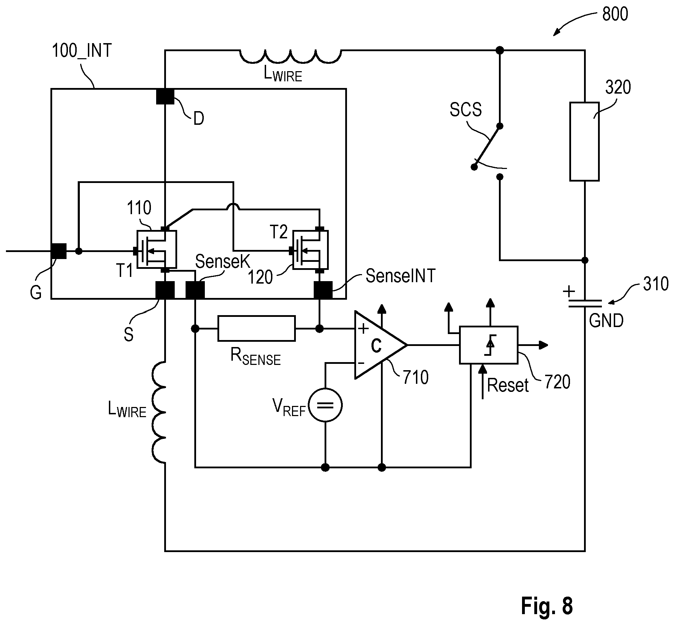

Figure 8 illustrating an exemplary circuitry 800 for load current switching and load current sensing which may be identical to the circuitry 700 except that the load 320 is connected to positive node rather than to the ground (GND) node of the power supply 310, i.e. the circuitry 800 may relates to an overcurrent detection of a low side switch. Reference is made to the above description to avoid reiteration. It is to be noted that the upward arrows in Figures 6, 7 and 8 are directed to an auxiliary power supply (not shown) used to power the operational amplifier 510 (Figure 6), the comparator 710 and the latch 720 (Figures 7 and 8).

In general, both types of transistor packages, i.e. the first type transistor package as exemplified by transistor package 100_INT of Figure 1A and the second type transistor package as exemplified by transistor package 100_EXT of Figure 1B, may each be used for all methods of sensing a load current as disclosed herein. In the following the first method of sensing a load current, which relies on measuring the voltage drop across the sense resistance R_{SENSE}, will be referred to as "DS voltage sensing" (and is illustrated for example in Figures 3 and 4). This method may also be termed R_{ON}(T1)-sensing. The second method of sensing a load current, which relies on regulating a sense current flowing through the sense transistor T2 or T2_{EXT} and measuring this sense current, will be referred to in the following as the "load current mirroring" method (and is illustrated for example in Figures 5 and 6). The third method of sensing a load current, which relies on comparing a given reference voltage with a voltage at the first type sense terminal SenseINT, will be referred to in the following as the "reference voltage comparison" method (and is illustrated for example in Figures 7 and 8).

Depending on whether the "DS voltage sensing" method or the "load current mirroring" method or the "reference voltage comparison" method is used for sensing the load current, the first type transistor package (e.g. transistor package 100_INT) and the second type transistor package (e.g. transistor package 100_EXT) may have different specifications in terms of the second chip 120 (including the sense transistor T2 or T2_{EXT}).

### "DS voltage sensing" method

When using the "DS voltage sensing" method, the sense transistor T2 (or T2_{EXT}) may, e.g., have an on-resistance value R_{ON}(T2) of equal to or greater than or less than 100 mΩ, 300 mΩ, 500 mΩ, 700 mΩ, or 1 Ω. Hence, a ratio R_{ON}(T2)/R_{ON}(T1) may, e.g., be equal to or greater than or less than 20 or 50 or 100 or 200 or 300. It is to be noted that typical values of R_{ON}(T1) are between 1 mΩ and 100 mΩ, in particular between 2 mΩ and 30 mΩ.

### "Load current mirroring" method

When using the "load current mirroring" method, the sense transistor T2 (or T2_{EXT}) may, e.g., have an on-resistance value R_{ON}(T2) of equal to or less than or greater than 1 Ω, 2 Ω, 3 Ω, 4 Ω, or 5 Ω. That is, the on-resistance value R_{ON}(T2) of the sense transistor T2 (or T2_{EXT})is chosen substantially larger than the on-resistance value R_{ON}(T2) for a first or second type transistor package (100_INT or 100_EXT) when the "DS voltage sensing" method is chosen. Hence, a ratio R_{ON}(T2)/R_{ON}(T1) may, e.g., be equal to or greater than or less than 1000 or 2000 or 3000 or 4000 or 5000. The on-resistance R_{ON}(T1) of the load transistor T1 for load current switching is independent of the method of sensing the load current, i.e. the load transistor T1 may always have the specifications as indicated above.

### "Reference voltage comparison" method

When using the "reference voltage comparison" method, the same applies as mentioned above in conjunction with the "DS voltage sensing" method.

Stated differently, depending on the customer's preference on whether to use the "DS voltage sensing" method or the "load current mirroring" method or the "reference voltage comparison" method for sensing the load current, the customer may choose to purchase a transistor package having or being configured to be operated at a ratio R_{ON}(T2)/R_{ON}(T1) of equal to or greater or less than 1000 or 2000 or 5000 or of equal to or greater or less than 20 or 50 or 100 or 200 or 300. In both cases, the customer may further choose to either purchase a first type transistor package or a second type transistor package (e.g. 100_INT or 100_EXT).

It is to be noted that the semiconductor area of the sense transistor T2 (or T2_{EXT}) used for a transistor package destined for the "DS voltage sensing" method or the "reference voltage comparison" method may be equal to the semiconductor area of a sense transistor T2 (or T2_{EXT}) used for a transistor package destined for the "load current mirroring" method. However, since the on-resistance value R_{ON}(T2) of the transistor T2 (or T2_{EXT}) adapted to the "load current mirroring" method T2 may be a factor of about 100 greater than the on-resistance value R_{ON}(T2) of the transistor T2 (or T2_{EXT}) adapted to the "DS voltage sensing" or "reference voltage comparison" method, this difference in on-resistance can, e.g., be implemented by deactivating a high percentage (e.g. 99%) of the transistor cells in the sense transistor T2 (or T2_{EXT}) in or for a transistor package destined for the "load current mirroring" method.

For all types of transistor packages and load current sensing methods used, the sense transistor T2 (or T2_{EXT}) needs to be protected against carrying or switching the load current. To this end, for instance, the threshold voltage Vₜₕ(T2) of the sense transistor T2 (or T2_{EXT}) may be chosen higher than a threshold voltage Vₜₕ(T1) of the load transistor T1 by, e.g., 20% of the threshold voltage Vₜₕ(T1) of the load transistor T1. For instance, the threshold voltage Vₜₕ(T2) of the sense transistor T2 (or T2_{EXT}) may be chosen higher than a threshold voltage Vₜₕ(T1) of the load transistor T1 by, e.g., at least 1.0 V or 1.5 V or 2.0 V or 3.0 V.

Both these measures (alone or in combination) allow to ensure that the load current is carried by the load transistor T1 rather than by the sense transistor T2, in particular during an initial switching phase in which the load transistor T1 is switched on. The sense transistor T2, T2_{EXT} may thus be seen as an "additive switch" which, however, is not used for load current switching (i.e. does not transmit power) but is used exclusively for load current sensing.

Further, the breakdown voltage V_{Br}(T2) of the sense transistor T2 (or T2_{EXT}) is be chosen higher than a breakdown voltage V_{Br}(T1) of the load transistor T1 by at least 5% of the breakdown voltage of the load transistor (T1). For instance, a breakdown voltage of the sense transistor (T2) may be higher than a breakdown voltage of the load transistor (T1) by at least 50 V or 100 V or 200 V or 300 V. This ensures that an occurrence of an avalanche breakdown is reliably confined to the load transistor T1 so that the sense transistor T2 (or T2_{EXT}) is not impacted by any such event.

All types of transistor packages described herein may be configured to switch high currents (e.g. equal to or greater than 50 A or 100 A or 150 A or 200 A or 250 A) and/or high voltages (e.g. equal to or greater than 100 V or 200 V or 300 V or 400 V or 500 V). Possible applications of the transistor packages are switched-mode voltage converters such as, e.g., a buck converter, a boost converter, a flyback converter, or the like.

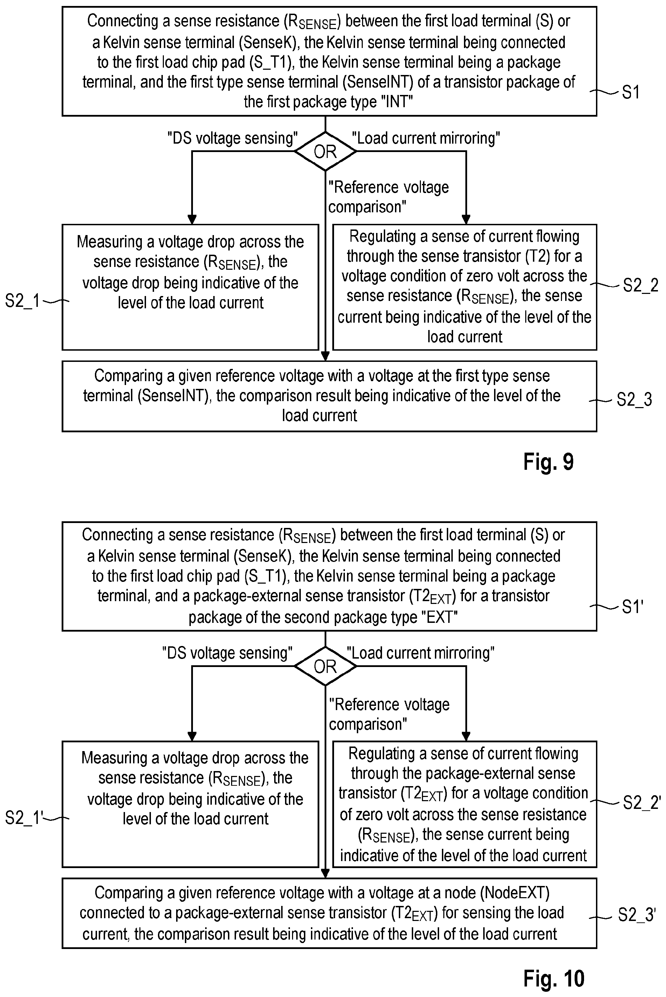

Figure 9 illustrates a flowchart of an exemplary method of sensing a load current applicable to a transistor package of the first package type, e.g. transistor package 100_INT.

At S1 a sense resistance (R_{SENSE}) is connected between the first load terminal (S) or a Kelvin sense terminal (SenseK), the Kelvin sense terminal (SenseK) being connected to the first load chip pad (S_T1), the Kelvin sense terminal (SenseK) being a package terminal, and the sense terminal (SenseINT) of a transistor package of the first package type "INT".

If the "DS voltage sensing" method is applied, the voltage drop across the sense resistance (R_{SENSE}) is measured at S2_1. The voltage drop is indicative of the level of the load current. This process has been described in more detail above with reference to "DS voltage sensing".

Alternatively, if the "load current mirroring" method is applied, a sense current flowing through the sense transistor (T2) may be regulated for a voltage condition of zero volt across the (pulldown) sense resistance (R_{SENSE}) at S2_2. The sense current is indicative of the level of the load current. This process has been described in more detail above with reference to "load current mirroring".

Alternatively, if the "reference voltage comparison" method is applied, a given reference voltage is compared with a voltage at the first type sense terminal at S2_3. The comparison result is indicative of the level of the load current. This process has been described in more detail above with reference to "reference voltage comparison".

Figure 10 is a flowchart illustrating an exemplary method of sensing a load current applicable to a transistor package of the second package type, e.g. transistor package 100_EXT.

At S1' a sense resistance (R_{SENSE}) is connected between the first load terminal S or a Kelvin sense terminal (SenseK), the Kelvin sense terminal (SenseK) being connected to the first load chip pad (S_T1), the Kelvin sense terminal (SenseK) being a package terminal, and a package-external sense transistor T2_{EXT} for a transistor package of the second package type "EXT".

If the "DS voltage sensing" method is applied, the voltage drop across the sense resistance (R_{SENSE}) is measured at S2_1'. The voltage drop is indicative of the level of the load current. This process has been described in more detail above with reference to "DS voltage sensing".

Alternatively, if the "load current mirroring" method is applied, a sense current flowing through the package-external sense transistor (T2_{EXT}) may be regulated for a voltage condition of zero volt across the (pulldown) sense resistance (R_{SENSE}) at S2_2'. The sense current is indicative of the level of the load current. This process has been described in more detail above with reference to "load current mirroring".

Alternatively, if the "reference voltage comparison" method is applied, a given reference voltage is compared with a voltage at a node (NodeEXT) connected to a package-external sense transistor (T2_{EXT}) for sensing the load current at S2_3'. The comparison result is indicative of the level of the load current. This process has been described in more detail above with reference to "reference voltage comparison".

In all transistor packages described herein, the load transistor T1 may, e.g., be made of any semiconductor material, e.g. Si, SiC, SiGe, GaAs, GaN, AlGaN, InGaAs, InAlAs, etc. The load transistor T1 may, e.g., be an IGBT (insulated-gate bipolar transistor) device or a MOSFET device, in particular a superjunction (SJ) MOSFET device.

For all transistor packages described herein, the sense transistor T2 (or T2_{EXT}) may, e.g., typically be made of Si. The sense transistor T2 (or T2_{EXT}) may be of the same or of a different transistor type than the load transistor T1. For instance, the sense transistor T2 (or T2_{EXT}) may, e.g., be (also) an IGBT device or a MOSFET device, in particular a SJ MOSFET device. However, it is also possible that the sense transistor T2 (or T2_{EXT}) is, e.g., a lateral or a planar transistor.

That is, since the load transistor T1 and the sense transistor T2 (or T2_{EXT}) are always implemented in different chips 110 and 120, the transistor packages of the first and second type (e.g. transistor package 100_INT and transistor package 100_EXT) could provide for a variety of chip combinations for implementing the load and sense transistors T1, T2 (or T2_{EXT}). Further, the first and second type transistor packages increase the versatility and variability of circuitry for load current switching and load current sensing for various applications. Differently put, the transistor packages described above allow the customer to obtain low-cost power switches provided with a load current sense modality and adapted to or adaptable to their specific needs.

Although specific embodiments have been illustrated and described herein, it will be appreciated by those of ordinary skill in the art that a variety of modifications of the specific embodiments shown and described is possible without departing from the scope of the present invention. This application is intended to cover any adaptations or variations of the specific embodiments discussed herein. The invention is defined by the claims.

## Claims

1. A transistor package (100), comprising:
a first chip (110) comprising a load transistor (T1) for switching a load current;
a first load terminal (S),
a second load terminal (D), and
a control terminal (G), wherein the first load terminal (S), the second load terminal (D) and the control terminal (G) are package terminals,
wherein the first load terminal (S) is connected to a first load chip pad (S_T1) of the load transistor (T1), the second load terminal (D) is connected to a second load chip pad (D_T1) of the load transistor (T1) and the control terminal (G) is connected to a control chip pad (G_T1) of the load transistor (T1); the package (150) further comprising:
according to a first package type (100_INT)
a second chip (120), the second chip (120) comprising a sense transistor (T2) for sensing the load current, and
a first type sense terminal (SenseINT) connected to the sense transistor (T2), the first type sense terminal (SenseINT) being a package terminal, wherein a control chip pad (G_T2) of the sense transistor (T2) is connected to the control terminal (G), wherein a breakdown voltage of the sense transistor (T2) is higher than a breakdown voltage of the load transistor (T1) by at least 5% of the breakdown voltage of the load transistor (T1); or
according to a second package type (100_EXT)
a Kelvin sense terminal (SenseK), the Kelvin sense terminal (SenseK) being connected to the first load chip pad (S_T1), the Kelvin sense terminal (SenseK) being a package terminal; and
a second type sense terminal (SenseEXT) connected to the second load chip pad (D_T1) of the load transistor (T1) via a Kelvin connection, the second type sense terminal (SenseEXT) being a package terminal accessible for external load current sensing.

2. The transistor package of claim 1, wherein a ratio R_{ON}(T2)/R_{ON}(T1) is equal to or greater than 20 or 50 or 100 or 200 or 300, with R_{ON}(T1) is the on-resistance of the load transistor (T1) and R_{ON}(T2) is the on-resistance of the sense transistor (T2), the load transistor (T1) and the sense transistor (T2) are MOSFETs.

3. The transistor package of claim 1, wherein a ratio R_{ON}(T2)/R_{ON}(T1) is equal to or greater than 1000 or 2000 or 5000, with R_{ON}(T1) is the on-resistance of the load transistor (T1) and R_{ON}(T2) is the on-resistance of the sense transistor (T2), the load transistor (T1) and the sense transistor (T2) are MOSFETs.

4. The transistor package of any of claims 2 or 3, wherein R_{ON}(T1) is equal to or less than 100 mΩ.

5. The transistor package of any of the preceding claims, wherein a threshold voltage of the sense transistor (T2) is higher than a threshold voltage of the load transistor (T1) by at least 20% of the threshold voltage of the load transistor (T1), the load transistor (T1) and the sense transistor (T2) are MOSFETs.

6. The transistor package of any of the preceding claims, wherein the sense transistor (T2) and the load transistor (T1) of a transistor package of the first package type are mounted on a common leadframe (210).

7. A circuitry for load current switching and load current sensing, comprising:
the transistor package of claim 1, and
a sense resistance (R_{SENSE}) connected between the first load terminal (S) or a Kelvin sense terminal (SenseK), the Kelvin sense terminal (SenseK) being connected to the first load chip pad (S_T1), the Kelvin sense terminal (SenseK) being a package terminal, and
if the transistor package is of the first package type (100_INT) the first type sense terminal (SenseINT); or
if the transistor package is of the second package type (100_EXT) a node (NodeEXT) connected to a package-external sense transistor (T2_{EXT}) for sensing the load current.

8. The circuitry of claim 7, further comprising a voltage measurement device (350) configured to measure a voltage drop across the sense resistance (R_{SENSE}), the voltage drop being indicative of the level of the load current.

9. The circuitry of claim 7, further comprising:
a regulator (REG) configured to regulate a sense current for a voltage condition of zero volt across the sense resistance (R_{SENSE}) , wherein,
if the transistor package is of the first package type (100_INT) the sense current is the current flowing through the sense transistor (T2); or
if the transistor package is of the second package type (100_EXT) the sense current is the current flowing through the package-external sense transistor (T2_{EXT}), and
the sense current being indicative of the level of the load current.

10. The circuitry of claim 9, wherein the regulator (REG) is configured to set a potential
at the first type sense terminal (SenseINT) if the transistor package is of the first package type (100_INT); or
at the node (NodeEXT) if the transistor package is of the second package type (100_EXT).

11. The circuitry of claim 7, further comprising a comparator configured to compare a given reference voltage with
a voltage at the first type sense terminal (SenseINT) if the transistor package is of the first package type (100_INT); or
a voltage at a node (NodeEXT) connected to a package-external sense transistor (T2_{EXT}) for sensing the load current if the transistor package is of the second package type (100_EXT), wherein an output of the comparator is indicative of the level of the load current.

12. The circuitry of claim 11, further comprising a latch coupled to the output of the comparator.

13. A method of sensing a load current, the method comprising:
connecting a sense resistance (R_{SENSE}) between the first load terminal (S) or a Kelvin sense terminal (SenseK), the Kelvin sense terminal (SenseK) being connected to the first load chip pad (S_T1), the Kelvin sense terminal (SenseK) being a package terminal, and the first type sense terminal (SenseINT) of a transistor package of the first package type (100_INT) of claim 1, and
measuring a voltage drop across the sense resistance (R_{SENSE}), the voltage drop being indicative of the level of the load current, or
regulating a sense current flowing through the sense transistor (T2) for a voltage condition of zero volt across the sense resistance (R_{SENSE}), the sense current being indicative of the level of the load current, or
comparing a given reference voltage with a voltage at the first type sense terminal (SenseINT), the comparison result being indicative of the level of the load current.

14. A method of sensing a load current, the method comprising:
connecting a sense resistance (R_{SENSE}) between the first load terminal (S) and a package-external sense transistor (T2_{EXT}) for a transistor package of the second package type (100_EXT) of claim 1; and
measuring a voltage drop across the sense resistance (R_{SENSE}), the voltage drop being indicative of the level of the load current, or
regulating a sense current flowing through the package-external sense transistor (T2_{EXT}) for a voltage condition of zero volt across the sense resistance (R_{SENSE}), the sense current being indicative of the level of the load current, or
comparing a given reference voltage with a voltage at a node (NodeEXT) connected to a package-external sense transistor (T2_{EXT}) for sensing the load current, the comparison result being indicative of the level of the load current.

## Patentansprüche

1. Transistorgehäuse (100), umfassend:
einen ersten Chip (110), der einen Lasttransistor (T1) zum Schalten eines Laststroms umfasst;
einen ersten Lastanschluss (S),
einen zweiten Lastanschluss (D), und
einen Steueranschluss (G), wobei der erste Lastanschluss (S), der zweite Lastanschluss (D) und der Steueranschluss (G) Gehäuseanschlüsse sind,
wobei der erste Lastanschluss (S) mit einem ersten Lastchippad (S_T1) des Lasttransistors (T1) verbunden ist, der zweite Lastanschluss (D) mit einem zweiten Lastchippad (D_T1) des Lasttransistors (T1) verbunden ist und der Steueranschluss (G) mit einem Steuerchippad (G_T1) des Lasttransistors (T1) verbunden ist; wobei das Gehäuse (150) ferner umfasst:
gemäß einem ersten Gehäusetyp (100_INT)
einen zweiten Chip (120), wobei der zweite Chip (120) einen Erfassungstransistor (T2) zum Erfassen des Laststroms umfasst, und
einen Erfassungsanschluss ersten Typs (SenseINT), der mit dem Erfassungstransistor (T2) verbunden ist, wobei der Erfassungsanschluss ersten Typs (SenseINT) ein Gehäuseanschluss ist, wobei ein Steuerchippad (G_T2) des Erfassungstransistors (T2) mit dem Steueranschluss (G) verbunden ist, wobei eine Durchbruchspannung des Erfassungstransistors (T2) um mindestens 5 % der Durchbruchspannung des Lasttransistors (T1) höher ist als eine Durchbruchspannung des Lasttransistors (T1); oder gemäß einem zweiten Gehäusetyp (100_EXT) einen Kelvin-Erfassungsanschluss (SenseK), wobei der Kelvin-Erfassungsanschluss (SenseK) mit dem ersten Lastchippad (S_T1) verbunden ist, wobei der Kelvin-Erfassungsanschluss (SenseK) ein Gehäuseanschluss ist; und
einen Erfassungsanschluss (SenseEXT) zweiten Typs, der über eine Kelvin-Verbindung mit dem zweiten Lastchippad (D_T1) des Lasttransistors (T1) verbunden ist, wobei der Erfassungsanschluss (SenseEXT) zweiten Typs ein Gehäuseanschluss ist, der für externe Laststromerfassung zugänglich ist.

2. Transistorgehäuse nach Anspruch 1, wobei ein Verhältnis R_{ON} (T2)/R_{ON} (T1) gleich oder größer als 20 oder 50 oder 100 oder 200 oder 300 ist, wobei R_{ON} (T1) der Einschaltwiderstand des Lasttransistors (T1) ist und R_{ON} (T2) der Einschaltwiderstand des Erfassungstransistors (T2) ist, wobei der Lasttransistor (T1) und der Erfassungstransistor (T2) MOSFETs sind.

3. Transistorgehäuse nach Anspruch 1, wobei ein Verhältnis R_{ON} (T2)/R_{ON} (T1) gleich oder größer als 1000 oder 2000 oder 5000 ist, wobei R_{ON} (T1) der Einschaltwiderstand des Lasttransistors (T1) ist und R_{ON} (T2) der Einschaltwiderstand des Erfassungstransistors (T2) ist, wobei der Lasttransistor (T1) und der Erfassungstransistor (T2) MOSFETs sind.

4. Transistorgehäuse nach einem der Ansprüche 2 oder 3, wobei R_{ON} (T1) gleich oder kleiner als 100 mΩ ist.

5. Transistorgehäuse nach einem der vorhergehenden Ansprüche, wobei eine Schwellenspannung des Erfassungstransistors (T2) um mindestens 20 % der Schwellenspannung des Lasttransistors (T1) höher als eine Schwellenspannung des Lasttransistors (T1) ist, wobei der Lasttransistor (T1) und der Erfassungstransistor (T2) MOSFETs sind.

6. Transistorgehäuse nach einem der vorhergehenden Ansprüche, wobei der Erfassungstransistor (T2) und der Lasttransistor (T1) eines Transistorgehäuses des ersten Gehäusetyps auf einem gemeinsamen Leiterrahmen (210) montiert sind.

7. Schaltungsanordnung zum Laststromschalten und zur Laststromerfassung, umfassend:
das Transistorgehäuse nach Anspruch 1, und
einen Erfassungswiderstand (R_{SENSE}) , der zwischen dem ersten Lastanschluss (S) oder einem Kelvin-Erfassungsanschluss (SenseK) verbunden ist, wobei der Kelvin-Erfassungsanschluss (SenseK) mit dem ersten Lastchippad (S_T1) verbunden ist, wobei der Kelvin-Erfassungsanschluss (SenseK) ein Gehäuseanschluss ist, und
falls das Transistorgehäuse vom ersten Gehäusetyp (100_INT) ist, den Erfassungsanschluss ersten Typs (SenseINT); oder
falls das Transistorgehäuse vom zweiten Gehäusetyp (100_EXT) ist, einen Knoten (NodeEXT), der mit einem gehäuseexternen Erfassungstransistor (T2_{EXT}) zum Erfassen des Laststroms verbunden ist.

8. Schaltungsanordnung nach Anspruch 7, ferner umfassend eine Spannungsmessvorrichtung (350), die dazu ausgelegt ist, einen Spannungsabfall über den Erfassungswiderstand (R_{SENSE}) zu messen, wobei der Spannungsabfall den Pegel des Laststroms angibt.

9. Schaltungsanordnung nach Anspruch 7, ferner umfassend:
einen Regler (REG), der dazu ausgelegt ist, einen Erfassungsstrom für einen Spannungszustand von null Volt über den Erfassungswiderstand (R_{SENSE}) zu regeln, wobei, falls das Transistorgehäuse vom ersten Gehäusetyp (100_INT) ist, der Erfassungsstrom der Strom ist, der durch den Erfassungstransistor (T2) fließt; oder
falls das Transistorgehäuse vom zweiten Gehäusetyp (100_EXT) ist, der Erfassungsstrom der Strom ist, der durch den gehäuseexternen Erfassungstransistor (T2_{EXT}) fließt, und
wobei der Erfassungsstrom den Pegel des Laststroms angibt.

10. Schaltungsanordnung nach Anspruch 9, wobei der Regler (REG) dazu ausgelegt ist, ein Potenzial einzustellen
an dem Erfassungsanschluss ersten Typs (SenseINT), falls das Transistorgehäuse vom ersten Gehäusetyp (100_INT) ist; oder
an dem Knoten (NodeEXT), falls das Transistorgehäuse vom zweiten Gehäusetyp (100_EXT) ist.

11. Schaltungsanordnung nach Anspruch 7, ferner umfassend einen Komparator, der dazu ausgelegt ist, eine gegebene Referenzspannung zu vergleichen mit
einer Spannung an dem Erfassungsanschluss ersten Typs (SenseINT), falls das Transistorgehäuse vom ersten Gehäusetyp (100_INT) ist; oder
einer Spannung an einem Knoten (NodeEXT), der mit einem gehäuseexternen Erfassungstransistor (T2_{EXT}) zum Erfassen des Laststroms verbunden ist, falls das Transistorgehäuse vom zweiten Gehäusetyp (100_EXT) ist, wobei ein Ausgang des Komparators den Pegel des Laststroms angibt.

12. Schaltungsanordnung nach Anspruch 11, ferner umfassend einen Latch, der mit dem Ausgang des Komparators gekoppelt ist.

13. Verfahren zum Erfassen eines Laststroms, wobei das Verfahren umfasst:
Verbinden eines Erfassungswiderstands (R_{SENSE}) zwischen dem ersten Lastanschluss (S) oder einem Kelvin-Erfassungsanschluss (SenseK), wobei der Kelvin-Erfassungsanschluss (SenseK) mit dem ersten Lastchippad (S_T1) verbunden ist, wobei der Kelvin-Erfassungsanschluss (SenseK) ein Gehäuseanschluss ist, und dem Erfassungsanschluss ersten Typs (SenseINT) eines Transistorgehäuses des ersten Gehäusetyps (100_INT) nach Anspruch 1, und
Messen eines Spannungsabfalls über den Erfassungswiderstand (R_{SENSE}), wobei der Spannungsabfall den Pegel des Laststroms angibt, oder
Regeln eines Erfassungsstroms, der durch den Erfassungstransistor (T2) fließt, für einen Spannungszustand von null Volt über den Erfassungswiderstand (R_{SENSE}), wobei der Erfassungsstrom den Pegel des Laststroms angibt, oder
Vergleichen einer gegebenen Referenzspannung mit einer Spannung an dem Erfassungsanschluss ersten Typs (SenseINT), wobei das Vergleichsergebnis den Pegel des Laststroms angibt.

14. Verfahren zum Erfassen eines Laststroms, wobei das Verfahren umfasst:
Verbinden eines Erfassungswiderstands (R_{SENSE}) zwischen dem ersten Lastanschluss (S) und einem gehäuseexternen Erfassungstransistor (T2_{EXT}) für ein Transistorgehäuse des zweiten Gehäusetyps (100_EXT) nach Anspruch 1; und Messen eines Spannungsabfalls über den Erfassungswiderstand (R_{SENSE}), wobei der Spannungsabfall den Pegel des Laststroms angibt, oder
Regeln eines Erfassungsstroms, der durch den gehäuseexternen Erfassungstransistor (T2_{EXT}) fließt, für einen Spannungszustand von null Volt über den Erfassungswiderstand (R_{SENSE}), wobei der Erfassungsstrom den Pegel des Laststroms angibt, oder
Vergleichen einer gegebenen Referenzspannung mit einer Spannung an einem Knoten (NodeEXT),der mit einem gehäuseexternen Erfassungstransistor (T2_{EXT}) zum Erfassen des Laststroms verbunden ist, wobei das Vergleichsergebnis den Pegel des Laststroms angibt.

## Revendications

1. Boitier de transistor (100) comprenant :
une première puce (110) comprenant un transistor de charge (T1) pour commuter un courant de charge ;
une première borne de charge (S),
une deuxième borne de charge (D), et
une borne de commande (G), où la première borne de charge (S), la deuxième borne de charge (D) et la borne de commande (G) sont des bornes de boîtier,
où la première borne de charge (S) est connectée à un premier plot de puce de charge (S_T1) du transistor de charge (T1), la deuxième borne de charge (D) est connectée à un deuxième plot de puce de charge (D_T1) du transistor de charge (T1) et la borne de commande (G) est connectée à un plot de puce de commande (G_T1) du transistor de charge (T1) ; le boîtier (150) comprenant en outre :
selon un premier type de boîtier (100_INT) une deuxième puce (120), la deuxième puce (120) comprenant un transistor de détection (T2) pour détecter le courant de charge, et
une borne de détection de premier type (SenseINT) connectée au transistor de détection (T2), la borne de détection de premier type (SenseINT) étant une borne de boîtier, où un plot de puce de commande (G_T2) du transistor de détection (T2) est connecté à la borne de commande (G), une tension de claquage du transistor de détection (T2) étant supérieure à une tension de claquage du transistor de charge (T1) d'au moins 5 % de la tension de claquage du transistor de charge (T1) ; ou
selon un deuxième type de boîtier (100_EXT) une borne de détection Kelvin (SenseK), la borne de détection Kelvin (SenseK) étant connectée au premier plot de puce de charge (S_T1), la borne de détection Kelvin (SenseK) étant une borne de boîtier ; et
une borne de détection de deuxième type (SenseEXT) connectée au deuxième plot de puce de charge (D_T1) du transistor de charge (T1) par l'intermédiaire d'une connexion Kelvin, la borne de détection de deuxième type (SenseEXT) étant une borne de boîtier accessible pour la détection de courant de charge externe.

2. Boîtier de transistor selon la revendication 1, dans lequel un rapport R_{ON} (T2)/R_{ON} (T1) est égal ou supérieur à 20 ou 50 ou 100 ou 200 ou 300, R_{ON} (T1) étant la résistance à l'état passant du transistor de charge (T1) et R_{ON} (T2) étant la résistance à l'état passant du transistor de détection (T2), le transistor de charge (T1) et le transistor de détection (T2) étant des transistors MOSFET.

3. Boîtier de transistor selon la revendication 1, dans lequel un rapport R_{ON} (T2)/R_{ON} (T1) est égal ou supérieur à 1000 ou 2000 ou 5000, R_{ON} (T1) étant la résistance à l'état passant du transistor de charge (T1) et R_{ON} (T2) étant la résistance à l'état passant du transistor de détection (T2), le transistor de charge (T1) et le transistor de détection (T2) étant des transistors MOSFET.

4. Boîtier de transistor selon l'une quelconque des revendications 2 ou 3, dans lequel R_{ON} (T1) est égale ou inférieure à 100 mΩ.

5. Boîtier de transistor selon l'une quelconque des revendications précédentes, dans lequel une tension de seuil du transistor de détection (T2) est supérieure à une tension de seuil du transistor de charge (T1) d'au moins 20 % de la tension de seuil du transistor de charge (T1), le transistor de charge (T1) et le transistor de détection (T2) étant des transistors MOSFET.

6. Boîtier de transistor selon l'une quelconque des revendications précédentes, dans lequel le transistor de détection (T2) et le transistor de charge (T1) d'un boîtier de transistor du premier type de boîtier sont montés sur une grille de connexion commune (210).

7. Circuit pour la commutation de courant de charge et la détection de courant de charge, comprenant :
le boîtier de transistor selon la revendication 1, et
une résistance de détection (R_{SENSE}) connectée entre la première borne de charge (S) ou une borne de détection Kelvin (SenseK), la borne de détection Kelvin (SenseK) étant connectée au premier plot de puce de charge (S_T1), la borne de détection Kelvin (SenseK) étant une borne de boîtier, et
si le boîtier de transistor est du premier type de boîtier (100_INT), la borne de détection est du premier type (SenseINT) ; ou
si le boîtier de transistor est du deuxième type de boîtier (100_EXT), un nœud (NodeEXT) est connecté à un transistor de détection externe au boîtier (T2_{EXT}) pour détecter le courant de charge.

8. Circuit selon la revendication 7, comprenant en outre un dispositif de mesure de tension (350) configuré pour mesurer une chute de tension aux bornes de la résistance de détection (R_{SENSE}), la chute de tension étant indicative du niveau du courant de charge.

9. Circuit selon la revendication 7, comprenant en outre :
un régulateur (REG) configuré pour réguler un courant de détection pour une condition de tension de zéro volt aux bornes de la résistance de détection (R_{SENSE}), où si le boîtier de transistor est du premier type de boîtier (100_INT), le courant de détection est le courant traversant le transistor de détection (T2) ; ou
si le boîtier de transistor est du deuxième type de boîtier (100_EXT), le courant de détection est le courant traversant le transistor de détection externe au boîtier (T2_{EXT}), et
le courant de détection étant indicatif du niveau du courant de charge.

10. Circuit selon la revendication 9, dans lequel le régulateur (REG) est configuré pour établir un potentiel au niveau de la borne de détection du premier type (SenseINT) si le boîtier transistor est du premier type de boîtier (100_INT) ; ou
au niveau du nœud (NodeEXT) si le boîtier de transistor est du deuxième type de boîtier (100_EXT).

11. Circuit selon la revendication 7, comprenant en outre un comparateur configuré pour comparer une tension de référence donnée à
une tension au niveau de la borne de détection du premier type (SenseINT) si le boîtier transistor est du premier type de boîtier (100_INT) ; ou
une tension au niveau d'un nœud (NodeEXT) connecté à un transistor de détection externe au boîtier (T2_{EXT}) pour détecter le courant de charge si le boîtier de transistor est du deuxième type de boîtier (100_EXT), où une sortie du comparateur est indicative du niveau du courant de charge.

12. Circuit selon la revendication 11, comprenant en outre un verrou couplé à la sortie du comparateur.

13. Procédé de détection d'un courant de charge, le procédé comprenant les étapes suivantes :
connecter une résistance de détection (R_{SENSE}) entre la première borne de charge (S) ou une borne de détection Kelvin (SenseK), la borne de détection Kelvin (SenseK) étant connectée au premier plot de puce de charge (S_T1), la borne de détection Kelvin (SenseK) étant une borne de boîtier, et la borne de détection de premier type (SenseINT) d'un boîtier de transistor du premier type (100_INT) de boîtier selon la revendication 1, et
mesurer une chute de tension aux bornes de la résistance de détection (R_{SENSE}), la chute de tension étant indicative du niveau du courant de charge, ou
réguler un courant de détection circulant à travers le transistor de détection (T2) pour une condition de tension de zéro volt à travers la résistance de détection (R_{SENSE}) , le courant de détection étant indicatif du niveau du courant de charge, ou
comparer une tension de référence donnée à une tension au niveau de la borne de détection du premier type (SenseINT), le résultat de la comparaison étant indicatif du niveau du courant de charge.

14. Procédé de détection d'un courant de charge, le procédé comprenant les étapes suivantes :
connecter une résistance de détection (R_{SENSE}) entre la première borne de charge (S) et un transistor de détection externe au boîtier (T2_{EXT}) pour un boîtier de transistor du deuxième type de boîtier (100_EXT) selon la revendication 1 ; et
mesurer une chute de tension aux bornes de la résistance de détection (R_{SENSE}), la chute de tension étant indicative du niveau du courant de charge, ou
réguler un courant de détection circulant dans le transistor de détection externe au boîtier (T2_{EXT}) pour une condition de tension de zéro volt à travers la résistance de détection (R_{SENSE}), le courant de détection étant indicatif du niveau du courant de charge, ou
comparer une tension de référence donnée à une tension au niveau d'un nœud (NodeEXT) connecté à un transistor de détection externe au boîtier (T2_{EXT}) pour détecter le courant de charge, le résultat de la comparaison étant indicatif du niveau du courant de charge.
